# EUROPÄISCHE PATENTSCHRIFT

(11) **EP 1 266 404 B1**
(45) Veröffentlichungstag und Bekanntmachung des Hinweises auf die Patenterteilung: **27.07.2005**
(21) Anmeldenummer: 01915085.3
(22) Anmeldetag: 06.03.2001
(51) Int. Cl.: H01L 21/66, G01R 31/27

(54) **TEST-SCHALTUNGSANORDNUNG UND VERFAHREN ZUM TESTEN EINER VIELZAHL VON ELEKTRISCHEN KOMPONENTEN**
TEST CIRCUIT ARRANGEMENT AND A METHOD FOR TESTING A PLURALITY OF ELECTRIC COMPONENTS
ENSEMBLE CIRCUIT DE TEST ET PROCEDE POUR TESTER UNE PLURALITE DE COMPOSANTS ELECTRIQUES

(30) Priorität: 10.03.2000 DE 10011656
(43) Veröffentlichungstag der Anmeldung: 18.12.2002
(73) Patentinhaber: Infineon Technologies AG, 81669 München (DE)
(72) Erfinder: KOLLMER, Ute, 81737 München (DE); LINNENBANK, Carsten, 80636 München (DE); SCHAPER, Ulrich, 81737 München (DE); THEWES, Roland, 82194 Gröbenzell (DE)
(74) Vertreter: Viering, Jentschura & Partner
(86) Internationale Anmeldenummer: PCT/DE2001/000850
(87) Internationale Veröffentlichungsnummer: WO 2001/067507

(56) Entgegenhaltungen:
- M. EISELE ET AL.: "INTRA-DIE DEVICE PARAMETER VARIATIONS..." IEEE, IEDM 1995, 1995, Seiten 67-70, XP002170197 in der Anmeldung erwähnt
- THEWES ET AL.: "EXPLANATION AND QUANTITATIVE MODEL FOR THE MATCHING BEHAVIOR OF POLY-SILICON RESISTORS" IEEE, IEDM 1998, 6. - 9. Dezember 1998, Seiten 771-774, XP002170198 SAN FRANCISCO, CA, USA

## Beschreibung

Die Erfindung betrifft eine Test-Schaltungsanordnung sowie ein Verfahren zum Testen einer Vielzahl von elektrischen Komponenten, die miteinander gekoppelt sind.

Eine solche Test-Schaltungsanordnung und ein solches Verfahren sind aus [1] und [2] bekannt.

Bei der Herstellung von Halbleiterbauelementen, insbesondere bei der Herstellung von Chips auf Wafern tritt häufig das Problem auf, dass aufgrund der örtlichen Anordnung einzelner Schaltungselemente auf dem Wafer sowie aufgrund unterschiedlicher Bedingungen während der Herstellung des Wafers die gleichartige Schaltungselemente auf den Wafern unterschiedliche Eigenschaften aufweisen.

Ein übliches elektrisches Schaltungselement, das im Bereich der Halbleitertechnologie eingesetzt wird, ist ein Transistor, insbesondere ein MOS-Feldeffekttransistor.

Werden die MOS-Feldeffekttransistoren in Analogschaltungen eingesetzt, so ist es oftmals erforderlich, möglichst genaue Kenntnis über die Eigenschaften der Schaltungselemente, die bei einem bestimmten Herstellungsprozess unter vorgegebenen Herstellungsbedingungen hergestellt werden, zu besitzen und damit über deren Verhalten in einer Analogschaltung.

Aufgrund der oben dargelegten Unterschiede und Unregelmäßigkeiten beim Herstellungsprozess eines Wafers kommt es bei den Transistoren selbst innerhalb eines Chips zu stark unterschiedlichen Eigenschaften.

Diese unterschiedlichen Eigenschaften der Transistoren werden üblicherweise als ein Mismatching der (MOS)-Feldeffekttransistoren bezeichnet.

Dieses Mismatching, das heißt die unterschiedlichen Eigenschaften der Feldeffekttransistoren in einem Chip oder Wafer bzw. bei Transistoren von Chips oder Wafern, die unter gleichen Herstellungsbedingungen hergestellt worden sind, führen, wenn ein Schaltungsdesigner keine genaue Kenntnis über die Eigenschaften des jeweils verwendeten Feldeffekttransistors zu erheblichen Unsicherheiten insbesondere beim Entwurf einer analogen elektrischen Schaltung, die solche Feldeffekttransistoren enthält.

Aus diesem Grund ist es erforderlich, Kenntnisse über die Eigenschaften hergestellter Feldeffekttransistoren zu erlangen.

Zum Ermitteln der Eigenschaften der Transistoren kann eine Teststruktur, die auf einem Referenz-Wafer, der unter den zu untersuchenden Herstellungsbedingungen ebenfalls hergestellt worden ist, mit Referenz-Transistoren, eingesetzt werden.

Die mittels einer solchen Teststruktur ermittelten Eigenschaften des Feldeffekttransistors bzw. der Feldeffekttransistoren, die unter gleichen Herstellungsbedingungen hergestellt worden sind wie der Referenz-Wafer mit dem Referenz-Feldeffekttransistoren, werden dem Schaltungsdesigner zur Verfügung gestellt, der diese Eigenschaften in sein Design einer Schaltung mit einfließen lassen kann, wodurch ein verlässlicherer und zuverlässigerer Entwurf einer elektrischen insbesondere analogen Schaltung mit solchen Feldeffekttransistoren möglich wird.

Grundlagen über das sogenannte Mismatching sind in [3] und [4] beschrieben.

Die aus [1] und [2] bekannte Test-Schaltungsanordnung weist zu testende Transistoren auf, die in einer Matrix in Spalten und Zeilen angeordnet sind. Mit den zu testenden Transistoren sind ein Spaltendecoder und ein Zeilendecoder gekoppelt, die gemeinsam als Adressdecoder zur Auswahl des jeweils zu testenden Transistors dienen.

Weiterhin sind zwischen die Spaltendecoder und Zeilendecoder Auswahltransistoren zum Abkoppeln bzw. Auswählen der zu testenden Transistoren geschaltet.

Jeder zu testende Transistor ist in Diodenschaltung angeordnet, das heißt der Gate-Anschluss des zu testenden Feldeffekttransistors ist mit dessen Drain-Anschluss kurzgeschlossen.

Mit der aus [1] und [2] beschriebenen Test-Schaltungsanordnung wird das Großsignalverhalten der zu testenden Feldeffekttransistoren, die miteinander gekoppelt und in einer "großen" Entfernung von wenigen mm voneinander angeordnet sind, bestimmt.

Ein Testen unterschiedlicher elektrischer Komponenten ist mit bekannten Test-Schaltungsanordnung automatisiert nicht möglich.

Insbesondere bei einer Teststruktur von zu testenden elektrischen Komponenten, die weit voneinander entfernt angeordnet sind, beispielsweise mehrere Millimeter, treten aufgrund der elektrischen Verbindungsleitungen zwischen den einzelnen zu testenden elektrischen Komponenten parasitäre Spannungsabfälle, das heißt parasitäre Effekte auf.

Diese Spannungsabfälle verfälschen das Messergebnis und somit die Testergebnisse, wodurch die Ergebnisse, die einem Schaltungsdesigner zu Verfügung gestellt werden über die einzelnen elektrischen Komponenten, unpräzise sind und insbesondere bei dem Entwurf von analogen Schaltungen zu unzuverlässigen und teilweise nicht funktionierenden oder außerhalb einer vorgegebenen Spezifikation liegenden analogen Schaltungen führen.

Weiterhin ist in [5] eine Schaltungsanordnung mit einer Testschaltung beschrieben.

Somit liegt der Erfindung das Problem zugrunde eine Test-Schaltungsanordnung sowie ein Verfahren zum Testen einer Vielzahl von elektrischen Komponenten anzugeben, mit der bzw. mit dem ein exakteres und zuverlässigeres Testen der zu testenden elektrischen Komponenten ermöglicht wird.

Das Problem wird durch die Test-Schaltungsanordnung sowie durch das Verfahren mit den Merkmalen gemäß den unabhängigen Patentansprüchen gelöst.

Eine Test-Schaltungsanordnung zum Testen einer Vielzahl von elektrischen Komponenten weist eine Vielzahl von zu testenden elektrischen Komponenten auf, die miteinander gekoppelt sind. Weiterhin ist eine mit den zu testenden elektrischen Komponenten gekoppelte elektrische Auswahleinheit zum Auswählen mindestens einer zu testenden elektrischen Komponente vorgesehen. Mit einem Regelelement, das mit den zu testenden elektrischen Komponenten gekoppelt ist, ist ein parasitärer Spannungsabfall in der Test-Schaltungsanordnung zumindest teilweise kompensierbar.

Bei einem Verfahren zum Testen einer Vielzahl von elektrischen Komponenten, die miteinander gekoppelt sind, wird eine zu testende elektrische Komponente aus der Vielzahl von zu testenden elektrischen Komponenten mittels einer elektrischen Auswahleinheit ausgewählt. Durch die ausgewählte zu testende elektrische Komponente wird ein Teststrom geleitet oder eine Testspannung wird an die zu testende elektrische Komponente angelegt. Ein sich aufgrund des Teststroms oder der Testspannung ergebener Messstrom oder eine sich ergebende Messspannung wird erfasst, das heißt gemessen und im Rahmen der Messung wird ein sich ergebender parasitärer Spannungsabfall in der Test-Schaltungsanordnung mittels eines Regelelements zumindest teilweise kompensiert.

Durch die Erfindung wird es nun erstmals möglich, im Rahmen eines sogenannten Long-Distance Mismatchings, das heißt im Rahmen des Testens von elektrischen Komponenten auf einem Wafer über eine große Entfernung von mehreren Millimetern hinweg eine automatisierte Kompensation von Störeinflüssen zu ermöglichen, die insbesondere durch die Verbindungsleitungen, das heißt die Kopplungen zwischen den zu testenden Komponenten auftreten.

Eine solche Test-Schaltungsanordnung ist in der Regel entlang der Chips auf einem Referenz-Wafer angeordnet.

Da die gesamte Teststruktur sich im wesentlichen über den gesamten Referenz-Wafer erstreckt, ist es möglich, sich verändernde Eigenschaften der elektrischen Komponenten an verschiedenen Positionen innerhalb des Wafers zu erfassen.

Außerdem ist es aus diesem Grunde möglich, sich verändernde Eigenschaften der elektrischen Komponenten an verschiedenen Positionen innerhalb eines Chips zu erfassen.

Durch die Erfindung wird somit die Genauigkeit der Testergebnisse erheblich erhöht. Dies führt zu deutlich verbesserten, da auf einer verlässlicheren Beschreibung der Eigenschaften der elektrischen Komponenten basierenden, analogen Schaltungen, die mittels der elektrischen Komponenten, die auf Wafern, die gemäß dem gleichen Herstellungsverfahren unter den gleichen Herstellungsbedingungen wie der Referenz-Wafer hergestellt worden sind, erreicht werden.

Bevorzugte Weiterbildungen der Erfindung ergeben sich aus den abhängigen Ansprüchen.

Die im weiteren beschriebenen Ausgestaltungen der Erfindung betreffen sowohl die Test-Schaltungsanordnung als auch das Verfahren zum Testen einer Vielzahl miteinander gekoppelter elektrischer Komponenten.

Die elektrischen Komponenten können sein:
- mindestens ein Transistor, insbesondere
- mindestens ein pnp-Bipolartransistor,
- mindestens ein npn-Bipolartransistor,
- mindestens ein Feldeffekttransistor, insbesondere ein MOS-Feldeffekttransistor (z.B. NMOS-Feldeffekttransistor oder PMOS-Feldeffekttransistor),
- allgemein jede Art eines Transistors,
- mindestens eine Diode,
- mindestens ein elektrischer Widerstand, oder auch
- mindestens ein elektrischer Kondensator.

Die elektrischen Komponenten können in Komponentengruppen gruppiert angeordnet sein, wobei jede Komponentengruppe die gleichen elektrischen Komponenten enthält. In der Test-Schältungsanordnung können mehrere Komponentengruppen angeordnet sein, wobei jede Komponentengruppe mit der elektrischen Auswahleinheit gekoppelt ist.

Die elektrische Auswahleinheit kann ein Schieberegister aufweisen sowie ein Taktgeberelement zum Takten des Schieberegisters. Mittels des Schieberegisters, mit dem die einzelnen Kopplungen, mit denen die zu testenden elektrischen Komponenten gekoppelt sind, adressiert werden, kann somit die zu testende elektrische Komponente innerhalb der Test-Schaltungsanordnung auf einfache Weise vollständig, da alle Komponenten über die Verbindungsleitungen mittels des Schieberegisters sequentiell abgearbeitet werden, berücksichtigt werden und somit getestet werden.

Es ist darauf hinzuweisen, dass alternativ auch ein beliebiger Adressierungsmechanismus vorgesehen sein kann, beispielsweise kann die Auswahleinheit mittels freier Adressierungsregister gebildet werden, die von einer externen Steuereinheit mit den entsprechenden Adressen der jeweils zu testenden Komponente innerhalb der Vielzahl zu testenden Komponenten belegt werden.

In einer Weiterbildung der Erfindung ist es vorgesehen, dass das Regelelement ein elektrischer Operationsverstärker ist. Der invertierende Eingang ist mit einer Rückkopplung gekoppelt und der nichtinvertierende Eingang des Operationsverstärkers ist mit einem vorgebbaren Potential gekoppelt. Der Ausgang des Operationsverstärkers ist mit einer Vorwärtskopplung gekoppelt. Die Vorwärtskopplung ist mit jeder zu testenden elektrischen Komponente sowie ferner mit der Rückkopplung koppelbar.

Auf diese Weise ergeben sich an der die Vorwärtskopplung, die sich vorzugsweise über die gesamte Test-Schaltungsanordnung erstreckt aufgrund der im Bereich der integrierten Schaltungen "großen" Distanzen von einigen Millimetern parasitäre Spannungsabfälle. Diese werden durch die Rückführung der Vorwärtskopplung über die Rückkopplung an den invertierenden Eingang des Operationsverstärkers kompensiert und "automatisch" ausgeregelt. Damit haben parasitäre Effekte auf der Vorwärtskopplung, allgemein auf einen Teil der Kopplungen zwischen den zu testenden Komponenten keinen Einfluss auf einen sich ergebenden Messstrom oder eine sich ergebende Messspannung, das heißt allgemein auf das sich ergebende Testergebnis, das jeweils die ausgewählte elektrische Komponente charakterisiert.

Somit wird auf einfache und kostengünstige Weise eine sehr effiziente Kompensation der parasitären Spannungsabfälle an zumindest einem Teil der Verbindungsleitungen zwischen den einzelnen zu testenden elektrischen Komponenten erreicht.

Ferner kann ein elektrischer Spannungsmesser vorgesehen sein, der mit jeder zu testenden Komponente koppelbar ist.

Gemäß einer weiteren Ausgestaltung der Erfindung ist eine Stromquelle vorgesehen, die mit jeder zu testenden elektrischen Komponente koppelbar ist.

Es ist in diesem Zusammenhang darauf hinzuweisen, dass weder der elektrische Spannungsmesser (aufgrund seines großen Innenwiderstands), noch der hochohmige invertierende Eingang des Operationsverstärkers als auch die Stromquelle (wegen ihres sehr geringen Widerstands) praktisch keinen verfälschenden Einfluss auf das Testergebnis haben.

Um auch sich ändernde Eigenschaften, die sich entlang des Wafers in unterschiedlichen Richtungen ergeben, ermitteln zu können ist es gemäß einer weiteren Ausgestaltung der Erfindung vorgesehen, zumindest einen Teil der zu testenden elektrischen Komponenten in unterschiedlichen Orientierungen, vorzugsweise senkrecht zueinander, innerhalb der Test-Schaltungsanordnung anzuordnen.

Ein Ausführungsbeispiel der Erfindung ist in den Figuren dargestellt und wird im weiteren näher erläutert.

Es zeigen
- Figur 1: eine Test-Schaltungsanordnung gemäß einem Ausführungsbeispiel der Erfindung;
- Figur 2: ein Blockdiagramm der Test-Schaltungsanordnung mit einer Vielzahl von Komponentengruppen gemäß einem Ausführungsbeispiel der Erfindung;
- Figur 3: eine Skizze der gesamten Test-Schaltungsanordnung mit externen Anschlüssen zu deren Ansteuerung.

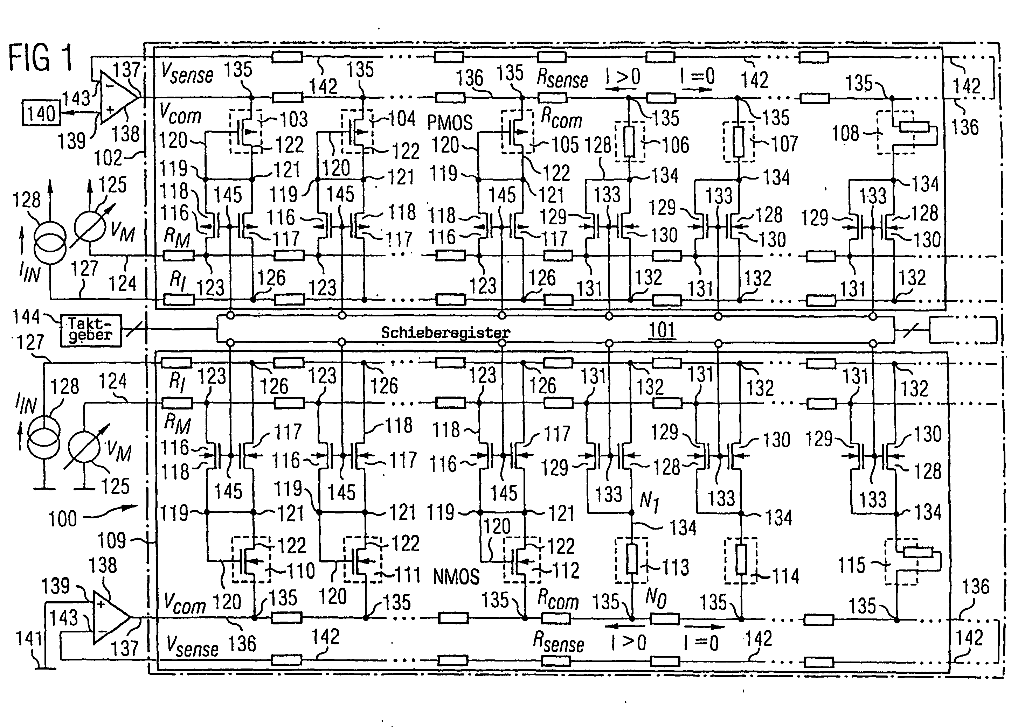

**Fig.1** zeigt eine Test-Schaltungsanordnung 100 mit einem Schieberegister 101 als elektrische Auswahleinheit und mehreren Komponentengruppen 102, 109. Jede Komponentengruppe 102, 109 enthält eine Vielzahl unterschiedlicher elektrischer Komponenten, zum Beispiel PMOS-Feldeffektransistoren, NMOS-Feldeffekttransistoren, Bipolartransistoren, Dioden, elektrische Widerstände, Kondensatoren, etc.

Gemäß dem Ausführungsbeispiel aus **Fig.1** sind folgende zu testende elektrische Komponenten in der ersten Komponentengruppe 102 enthalten:
- ein erster PMOS-Feldeffekttransistor 103,
- ein zweiter PMOS-Feldeffekttransistor 104,
- ein m-ter PMOS-Feldeffekttransistor 105,
- ein erster elektrischer Widerstand 106,
- ein zweiter elektrischer Widerstand 107,
- ein n-ter elektrischer Widerstand 108.

In der zweiten Komponentengruppe 109 sind gemäß dem Ausführungsbeispiel enthalten:
- ein erster NMOS-Feldeffekttransistor 110,
- ein zweiter NMOS-Feldeffekttransistor 111,
- ein i-ter NMOS-Feldeffekttransistor 112,
- ein n+1-ter elektrischer Widerstand 113,
- ein n+2-ter elektrischer Widerstand 114, und
- ein n+j-ter elektrischer Widerstand 115 enthalten.

Jede zu testende Komponente ist auf die im weiteren beschriebenen Weise jeweils mit einer Auswahlleitung des Schieberegisters 101, die durch das Schieberegister jeweils eindeutig adressierbar ist, gekoppelt.

Die jeweilige Leitung des Schieberegisters 101 ist bei einem Feldeffekttransistor als zu testendes elektrisches Element mit den Gates zweier Abkoppeltransistoren, einem ersten Abkoppeltransistor 116 und einem zweiten Abkoppeltransistor 117, die eine erste Abkoppeleinheit 118 bilden, gekoppelt.

Der Drain-Anschluss 119 des ersten Abkoppeltransistors 116 ist mit dem Gate-Anschluss 120 des jeweiligen zu testenden Feldeffekttransistors 103, 104, 105, 110, 111, 112 gekoppelt.

Der Drain-Anschluss 121 des zweiten Abkoppeltransistors 117 ist mit dem Drain-Anschluss 122 des jeweiligen zu testenden Feldeffekttransistors 103, 104, 105, 110, 111, 112 gekoppelt.

Ferner sind beide Gates über einen Gate-Anschluss 145 mit jeweils einer Adress-Leitung des Schieberegisters 101 gekoppelt.

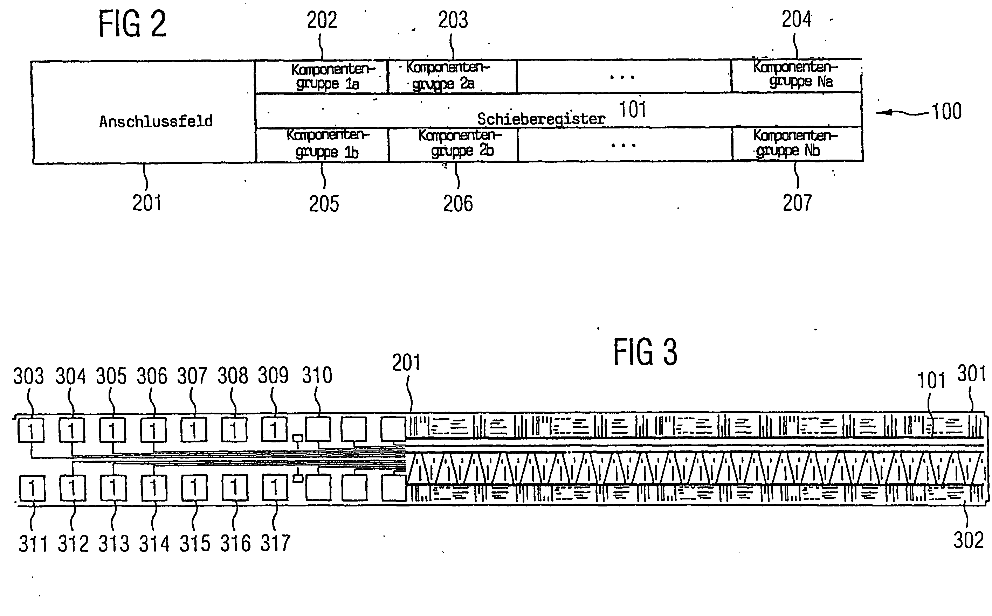

Der Source-Anschluss 123 des ersten Abkoppeltransistors 116 ist mit einer ersten Verbindungsleitung 124 als Messleitung gekoppelt. Mit der ersten Verbindungsleitung 124 ist ferner ein Spannungsmesser 125 gekoppelt. Der Spannungsmesser 125 ist üblicherweise nicht auf dem Wafer selbst angeordnet und es ist somit in der Test-Schaltungsanordnung 100 auf dem Chip ein Anschluss 315 (vgl. **Fig.3)** zum Anschließen des Spannungsmessers 125 vorgesehen.

Auf der ersten Verbindungsleitung 124 sind erste Parasitärwiderstände R_{M} dargestellt, mit denen die parasitären Eigenschaften der ersten Verbindungsleitung 124, das heißt insbesondere der Spannungsabfall an der ersten Verbindungsleitung 124 aufgrund eines durch die erste Verbindungsleitung 124 fließenden Parasitärstroms dargestellt.

Jeder Source-Anschluss 126 des jeweils zweiten Abkoppeltransistors 117 ist mit einer zweiten Verbindungsleitung 127 als Strompfad gekoppelt. Mit der zweiten Verbindungsleitung 127 ist eine sich üblicherweise ebenfalls außerhalb des Chips befindendende Stromquelle 128 gekoppelt, mittels der ein eingeprägter Strom I_{IN} entlang der zweiten Verbindungsleitung 127 über den zweiten Abkoppeltransistor 117, dem Drain-Anschluss 122 des jeweils zu testenden Feldeffekttransistors 103, 104, 105, 110, 111, 112 eingeprägt wird.

Auf der zweiten Verbindungsleitung 127 sind zweite Parasitärwiderstände R_{I} dargestellt zur Beschreibung eines parasitären Spannungsabfalls an der zweiten Verbindungsleitung 127 durch den Fluss des eingeprägten Stroms I_{IN} durch die zweite Verbindungsleitung 127.

Die oben dargestellte Struktur einer ersten Abkoppeleinheit 118 gilt für alle vierpoligen Elemente, insbesondere für alle Transistoren, wenn sie in der Test-Schaltungsanordnung 100 vorgesehen sind.

Bei einem zweipoligen Element, beispielsweise den elektrischen Widerständen 106, 107, 108, 113, 114, 115 ist eine zweite Abkoppeleinheit 128 mit einem Feldeffekttransistor als dritten Abkoppeltransistor 129 und einem Feldeffekttransistor als vierten Abkoppeltransistor 130 vorgesehen.

Der Source-Anschluss 131 des dritten Abkoppeltransistors 129 ist mit der ersten Verbindungsleitung 124 gekoppelt. Der Source-Anschluss 132 des vierten Abkoppeltransistors 130 ist mit der zweiten Verbindungsleitung 127 gekoppelt.

Ferner sind beide Gates über einen Gate-Anschluss 133 mit jeweils einer Adress-Leitung des Schieberegisters 101 gekoppelt.

Die Drain-Anschlüsse des dritten Abkoppeltransistors 129 bzw. des vierten Abkoppeltransistors 130 sind miteinander und mit einem ersten Anschluss 134 des elektrischen Widerstands 106, 107, 108, 113, 114, 115 gekoppelt.

Ein Ausgangs-Anschluss 135 des jeweils zu testenden Elements, das heißt der zu testenden elektrischen Komponente, im Fall eines Feldeffekttransistors 103, 104, 105, 110, 111, 112 der Source-Anschluss des Feldeffekttransistors und im Falle eines elektrischen Widerstands, das heißt allgemein eines zweipoligen Elements dessen zweiter Anschluss, ist jeweils mit einer dritten Verbindungsleitung 136 als eine sogenannte Common Ground Verbindungsleitung mit gemeinsamen Bezugspotential, im weiteren als Vorwärtskopplung 136 bezeichnet gekoppelt.

Die Vorwärtskopplung 136 ist an ihrem einen Ende mit einem Ausgang 137 eines Operationsverstärkers 138 gekoppelt. Der Operationsverstärker 138 ist üblicherweise ebenfalls außerhalb des Chips angeordnet und somit ist die Vorwärtskopplung 136 mit einem in **Fig.3** dargestellten

Anschluss gekoppelt.

Der nicht-invertierende Eingang 139 des Operationsverstärkers 138 ist mit einer vorgegebenen Betriebsspannung V_{DD} 140 bzw. mit dem Massepotential 141 gekoppelt. Weiterhin ist das andere Ende der Vorwärtskopplung 136 mit einer Rückwärtskopplung 142 als Senseleitung gekoppelt. Die Rückwärtskopplung 142 ist an den invertierenden Eingang 143 des Operationsverstärkers rückgekoppelt.

Ferner sind in **Fig.1** dritte Parasitärwiderstände R_{COM}, die die parasitären Eigenschaften der Vorwärtskopplung 136 beschreiben, dargestellt.

Auf der Rückwärtskopplung 142 sind vierte Parasitärwiderstände Rₛₑₙₛₑ zur Beschreibung des parasitären Verhaltens der Rückwärtskopplung 142 dargestellt.

Diese Struktur für eine Komponentengruppe ist für alle Komponentengruppen 102, 109,..., die sich in der Test-Schaltungsanordnung 100 befinden, grundsätzlich beliebig viele Komponentengruppen, gleich.

Durch die Rückwärtskopplung 142 werden die Spannungsabfälle der an dem dritten Parasitärwiderständen R_{COM} unter Verwendung des Operationsverstärkers 138 als Regelelement automatisch zumindest größtenteils kompensiert.

Damit ist eine sehr einfache Test-Schaltungsanordnung 100 angegeben, mit der eine große Anzahl zu testender elektrischer Komponenten automatisch auf ihre Eigenschaften hin untersucht, das heißt getestet werden können.

Durch geeignete Ansteuerung des Schieberegisters 101 werden die in der Test-Schaltungsanordnung 100 enthaltenen Spaltenverbindungen oder bei zweidimensionaler Anordnung der Komponentengruppen 102, 109 enthaltenen Zeilenverbindungen sukzessive nacheinander angesteuert.

Das Schieberegister 101 wird mittels eines Taktgebers 144 getaktet, das heißt gesteuert.

Wie **Fig.1** zu entnehmen ist, sind der n-te elektrische Widerstand 108 und der n+j-te elektrische Widerstand 115 gegenüber den anderen elektrischen Widerständen 106, 107, 113, 114 im wesentlichen senkrecht dazu angeordnet, um auch sich ändernde Eigenschaften von in der Orientierung unterschiedlich angeordneten elektrischen Komponenten innerhalb der Chips oder Wafer zu ermitteln.

**Fig.2** zeigt die Test-Schaltungsanordnung 100 mit einem Anschluss-Feld 201 und den Komponentengruppen 202, 203, 204, 205, 206, 207, die jeweils mit dem Schieberegister 101 gekoppelt sind und jeweils zwei Komponentengruppen 202, 205 bzw. 203, 206 bzw. 204, 207 sind gegenüberliegend hinsichtlich des Schieberegisters 101 angeordnet.

Das Anschlussfeld 201 weist, wie in **Fig.3** dargestellt, für jede Komponentenreihe 301, 302 Anschlüsse auf zur Ansteuerung der Test-Schaltungsanordnung 100:
- ein erster Anschluss 303 dient zum Anschließen einer Spannungsversorgung, mit der das Betriebspotential V_{DD} zur Verfügung gestellt wird,
- ein zweiter Anschluss 304 dient zum Anschließen der Stromquelle 132 der oberen Komponentenreihe 301,
- ein dritter Anschluss 305 dient zum Anschließen des Spannungsmessers 129 der oberen Komponentenreihe 301,
- ein vierter Anschluss 306 dient zum Anschließen des Ausgangs 137 des Operationsverstärkers 138 der oberen Komponentenreihe 301,
- ein fünfter Anschluss 307 dient zum Anschließen des nichtinvertierenden Eingangs 139 des Operationsverstärkers 138 der oberen Komponentenreihe 301,
- ein sechster Anschluss 308 dient zum Zuführen eines Rücksetzsignals zum Zurücksetzen des Schieberegisters 101,
- ein siebter Anschluss 309 und ein achter Anschluss 310 dienen zum Zuführen von Steuersignalen, das heißt zum Zuführen von Signalen zum Schieben der Auswahlbits in dem Schieberegister 101 zur Auswahl der jeweiligen zu testenden elektrischen Komponente,
- ein neunter Anschluss 311 dient zum Anschließen der Stromquelle 128 der unteren Komponentenreihe 302,
- ein zehnter Anschluss 312 dient zum Anschließen des Spannungsmessers 125 der unteren Komponentenreihe 302,
- ein elfter Anschluss 313 dient zum Anschließen des Ausgangs 137 des Operationsverstärkers 138 der unteren Komponentenreihe 302,
- ein zwölfter Anschluss 314 dient zum Anschließen des invertierenden Eingangs 143 des Operationsverstärkers 138 der unteren Komponentenreihe 302,
- ein dreizehnter Anschluss 315 dient zum Anschließen einer Spannungsversorgung, mit der das Betriebspotential V_{SS} zur Verfügung gestellt wird,
- ein vierzehnter Anschluss 316 dient zum Anschließen einer Spannungsversorgung, mit der ein vorgebbares Potential an das jeweilige Substratmaterial zur Verfügung gestellt wird,
- ein fünfzehnter Anschluss 317 dient zum Anschließen einer Spannungsversorgung, mit der ein vorgebbares Potential an die jeweiligen Wannenanschlüsse zur Verfügung gestellt wird.

In diesem Dokument sind folgende Veröffentlichungen zitiert:
[1] C. Linnenbank et al, What Do Matching Results of Medium Area MOSFETs Reveal for Large Area Devices in Typical Analog Applications?, Proceedings of the 28th European Solid-State Device Research Conference, ESSDRC 1998, Bordeaux, Frankreich, S. 104 - 107, 8. - 10. September 1998
[2] M. Eisele et al, Intra-Die Device Parameter Variations and Their Impact on Digital CMOS Gates at Low Supply Voltages, IEEE, IEDM 1995, S. 67 - 70, 1995
[3] K. R. Lakshmikumar et al., Characterization and Modeling of Mismatch in MOS Transistors for Precision Analog Design, IEEE Journal of Solid-State Circuits, Vol. SC-21, Nr. 6, S. 1057 - 1066, Dezember 1986
[4] M.J.M. Pelgrom et al, Transistor Matching in Analog CMOS Applications, IEEE, International Electron Devices Meeting, San Francisco, CA, IEDM 98, S. 915 - 918, 6. - 9. Dezember 1998
[5] EP 0 891 623 B1

### Bezugszeichenliste

- 100: Test-Schaltungsanordnung
- 101: Schieberegister
- 102: Erste Komponentengruppe
- 103: Erster PMOS-Feldeffekttransistor
- 104: Zweiter PMOS-Feldeffekttransistor
- 105: m-ter PMOS-Feldeffekttransistor
- 106: Erster elektrischer Widerstand
- 107: Zweiter elektrischer Widerstand
- 108: n-ter elektrischer Widerstand elektrischer Widerstand
- 109: Zweite Komponentengruppe
- 110: Erster NMOS-Feldeffekttransistor
- 111: Zweiter NMOS-Feldeffekttransistor
- 112: i-ter NMOS-Feldeffekttransistor
- 113: n+1-ter elektrischer Widerstand
- 114: n+2-ter elektrischer Widerstand
- 115: n+j-ter elektrischer Widerstand
- 116: Erster Abkoppeltransistor
- 117: Zweiter Abkoppeltransistor
- 118: Erste Abkoppeleinheit
- 119: Drain-Anschluss erster Abkoppeltransistor
- 120: Gate-Anschluss Feldeffekttransistor
- 121: Drain-Anschluss zweiter Abkoppeltransistor
- 122: Drain-Anschluss Feldeffekttransistor
- 123: Source-Anschluss erster Abkoppeltransistor
- 124: Erste Verbindungsleitung (Messleitung)
- 125: Spannungsmesser
- 126: Source-Anschluss zweiter Abkoppeltransistor
- 127: Zweite Verbindungsleitung (Strompfad)
- 128: Stromquelle
- 129: Dritter Abkoppeltransistor
- 130: Vierter Abkoppeltransistor
- 131: Source-Anschluss dritter Abkoppeltransistor
- 132: Source-Anschluss vierter Abkoppeltransistor
- 133: Gate-Anschluss dritter/vierter Abkoppeltransistor
- 134: Erster Anschluss elektrischer Widerstand
- 135: Ausgangs-Anschluss
- 136: Vorwärtskopplung (Common Ground)
- 137: Ausgang Operationsverstärker
- 138: Operationsverstärker
- 139: Nicht-invertierender Eingang Operationsverstärker
- 140: Betriebsspannung
- 141: Massepotential
- 142: Rückwärtskopplung (Senseleitung)
- 143: Invertierender Eingang Operationsverstärker
- 144: Taktgeber
- 145: Gate-Anschluss erster/zweiter Abkoppeltransistor
- R_{M}: Erste Parasitärwiderstände
- R_{I}: Zweite Parasitärwiderstände
- R_{COM}: Dritte Parasitärwiderstände
- Rₛₑₙₛₑ: Vierte Parasitärwiderstände

- 201: Anschluss-Feld
- 202: Komponentengruppe
- 203: Komponentengruppe
- 204: Komponentengruppe
- 205: Komponentengruppe
- 206: Komponentengruppe
- 207: Komponentengruppe

- 301: Obere Komponentenreihe
- 302: Untere Komponentenreihe
- 303: Erster Anschluss
- 304: Zweiter Anschluss
- 305: Dritter Anschluss
- 306: Vierter Anschluss
- 307: Fünfter Anschluss
- 308: Sechster Anschluss
- 309: Siebter Anschluss
- 310: Achter Anschluss
- 311: Neunter Anschluss
- 312: Zehnter Anschluss
- 313: Elfter Anschluss
- 314: Zwölfter Anschluss
- 315: Dreizehnter Anschluss
- 316: Vierzehnter Anschluss
- 317: Fünfzehnter Anschluss

## Patentansprüche

1. Test-Schaltungsanordnung (100) zum Testen einer Vielzahl von elektrischen Komponenten (103-115).
• mit einer Vielzahl von zu testenden elektrischen Komponenten (103-115), die miteinander gekoppelt sind,
• mit einer mit den zu testenden elektrischen Komponenten gekoppelten elektrischen Auswahleinheit (101) zum Auswählen mindestens einer zu testenden elektrischen Komponente,
• mit einem mit den zu testenden elektrischen Komponenten (103-115) gekoppelten Regelelement (138), mit dem ein parasitärer Spannungsabfall in der Test-Schaltungsanordnung (100) zumindest teilweise kompensierbar ist.

2. Test-Schaltungsanordnung (100) nach Anspruch 1,
bei der die elektrischen Komponenten (103-115) sind:
• mindestens ein Transistor, und/oder
• mindestens eine Diode, und/oder
• mindestens ein elektrischer Widerstand, und/oder
• mindestens ein elektrischer Kondensator.

3. Test-Schaltungsanordnung nach Anspruch 1 oder 2,
• bei der die elektrischen Komponenten (103-115) in Komponentengruppen (101,102) gruppiert angeordnet sind, wobei jede Komponentengruppe (101, 102) die gleichen elektrischen Komponenten (103-115) enthält,
• bei der mehrere Komponentengruppen (101,102) in der Test-Schaltungsanordnung angeordnet sind.

4. Test-Schaltungsanordnung nach einem der Ansprüche 1 bis 3, bei der die elektrische Auswahleinheit (101) ein Schieberegister aufweist, mit dem die elektrischen Komponenten (103-115) ausgewählt werden können.

5. Test-Schaltungsanordnung nach einem der Ansprüche 1 bis 4, bei der das Regelement (138) ein elektrischer Operationsverstärker ist,
• dessen invertierender Eingang (143) mit einer Rückkopplung (142) gekoppelt ist,
• dessen nicht invertierender Eingang (139) mit einem vorgebbaren Potential (140) gekoppelt ist,
• dessen Ausgang (137) mit einer Vorwärtskopplung (136) gekoppelt ist,
• wobei die Vorwärtskopplung (136) mit jeder zu testenden elektrischen Komponente (103-115) und mit der Rückkopplung (142) koppelbar ist.

6. Test-Schaltungsanordnung (100) nach einem der Ansprüche 1 bis 5, mit einem elektrischen Spannungsmesser (125), der mit jeder zu testenden elektrischen Komponente (103-115) koppelbar ist.

7. Test-Schaltungsanordnung (100) nach einem der Ansprüche 1 bis 6, mit einer Stromquelle (128), die mit jeder zu testenden elektrischen Komponente (103-115) koppelbar ist.

8. Test-Schaltungsanordnung (100) nach einem der Ansprüche 1 bis 7, bei dem die zu testenden elektrischen Komponenten (103-115) zumindest teilweise in unterschiedlichen Orientierungen angeordnet sind.

9. Verfahren zum Testen einer Vielzahl von elektrischen Komponenten (103-115), die miteinander gekoppelt sind,
• bei dem eine zu testende elektrische Komponente aus der Vielzahl von zu testenden elektrischen Komponenten (103-115) mittels einer elektrischen Auswahleinheit (101) ausgewählt wird,
• bei dem ein Teststrom durch die ausgewählte zu testende elektrische Komponente geführt wird oder eine Testspannung an die zu testende elektrische Komponente angelegt wird,
• bei dem ein sich aufgrund des Teststroms oder der Testspannung ergebender Messstrom oder eine sich ergebende Messspannung gemessen wird, und
• bei dem ein sich ergebender parasitärer Spannungsabfall in der Test-Schaltungsanordnung mittels eines Regelelements (138) zumindest teilweise kompensiert wird.

## Claims

1. A test circuit arrangement (100) for testing a plurality of electrical components (103-115),
• having a plurality of electrical components (103-115) which are to be tested and which are coupled to one another,
• having an electrical selection unit (101), coupled to the electrical components to be tested, for selecting at least one electrical component to be tested,
• having a control element (138) which is coupled to the electrical components (103-115) to be tested and with which a parasitic voltage drop in the test circuit arrangement (100) can be at least partially compensated.

2. The test circuit arrangement (100) as claimed in claim 1, in which the electrical components (103-115) are:
• at least one transistor, and/or
• at least one diode, and/or
• at least one electrical resistor, and/or
• at least one electrical capacitor.

3. The test circuit arrangement as claimed in claim 1 or 2,
• in which the electrical components (103-115) are arranged in groups (101, 102) of components, each group (101, 102) of components containing the same electrical components (103-115),
• in which a plurality of groups (101, 102) of components are arranged in the test circuit arrangement.

4. The test circuit arrangement as claimed in one of claims 1 to 3, in which the electrical selection unit (101) has a shift register with which the electrical components (103-115) can be selected.

5. The test circuit arrangement as claimed in one of claims 1 to 4, in which the control element (138) is an electrical operational amplifier,
• whose inverting input (143) is coupled to a feedback loop (142),
• whose non-inverting input (139) is coupled to a predefinable potential (140),
• whose output (137) is coupled to a forward coupling (136),
• it being possible to couple the forward coupling (136) to any electrical component (103-115) to be tested and to the feedback loop (142).

6. The test circuit arrangement (100) as claimed in one of claims 1 to 5, having an electrical voltmeter (125) which can be coupled to each electrical component (103-115) to be tested.

7. The test circuit arrangement (100) as claimed in one of claims 1 to 6, having a current source (128) which can be coupled to each electrical component (103-115) to be tested.

8. The test circuit arrangement (100) as claimed in one of claims 1 to 7, in which the electrical components (103-115) to be tested are arranged at least partially with different orientations.

9. A method for testing a plurality of electrical components (103-115) which are coupled to one another,
• in which an electrical component to be tested is selected from the plurality of electrical components (103-115) to be tested by means of an electrical selection unit (101),
• in which a test current is conducted through the selected electrical component to be tested or a test voltage is applied to the electrical component to be tested,
• in which a measuring current which results from the test current or the test voltage or a resulting measuring voltage is measured, and
• in which a resulting parasitic voltage drop in the test circuit arrangement is at least partially compensated by means of a control element (138).

## Revendications

1. Circuit de test (100) permettant de tester une pluralité de composants électriques (103-115), comprenant
• une pluralité de composants électriques à tester (103-115) couplés les uns avec les autres,
• une unité de sélection électrique (101) couplée avec les composants électriques à tester, pour la sélection d'au moins un composant électrique à tester,
• un élément de régulation (138) couplé avec les composants électriques à tester (103-115), et permettant de compenser au moins partiellement une chute de tension parasitaire dans le circuit de test (100).

2. Circuit de test (100) selon la revendication 1, dans lequel les composants électriques (103-105) sont :
• au moins un transistor, et/ou
• au moins une diode, et/ou
• au moins une résistance électrique, et/ou
• au moins un condensateur électrique.

3. Circuit de test (100) selon la revendication 1 ou 2, dans lequel
• les composants électriques (103-115) sont disposés de façon regroupée dans des groupes de composants (101, 102), chaque groupe de composants (101, 102) contenant les mêmes composants électriques (103-115),
• plusieurs groupes de composants (101, 102) sont disposés dans le circuit de test.

4. Circuit de test (100) selon l'une quelconque des revendications 1 à 3, dans lequel l'unité de sélection électrique (101) présente un registre à décalage permettant de sélectionner les composants électriques (103-115).

5. Circuit de test selon l'une quelconque des revendications 1 à 4, dans lequel l'élément de régulation (138) est un amplificateur opérationnel électrique,
• dont l'entrée inverseuse (143) est couplée avec un rétrocouplage (142),
• dont l'entrée non inverseuse (139) est couplée avec un potentiel pouvant être prédéterminé (140),
• dont la sortie (137) est couplée avec un couplage direct (136),
• le couplage direct (136) pouvant être couplé avec chaque composant électrique à tester (103-115) et avec le rétrocouplage (142).

6. Circuit de test (100) selon l'une quelconque des revendications 1 à 5, comprenant un voltmètre électrique (125) pouvant être couplé avec chaque composant électrique à tester (103-115).

7. Circuit de test (100) selon l'une quelconque des revendications 1 à 6, comprenant une source de courant (128) pouvant être couplée avec chaque composant électrique à tester (103-115).

8. Circuit de test (100) selon l'une quelconque des revendications 1 à 7, dans lequel les composants électriques à tester (103-115) sont au moins en partie disposés selon des orientation différentes.

9. Procédé de test d'une pluralité de composant électriques (103-115) couplés les uns avec les autres, selon lequel
• un composant électrique à tester est sélectionné parmi la pluralité de composants électriques à tester (103-115) au moyen d'une unité de sélection électrique (101),
• un courant de test est envoyé à travers le composant électrique à tester sélectionné ou une tension de test est appliquée au niveau du composant électrique à tester,
• un courant de mesure ou une tension de mesure résultant du courant de test ou de la tension de test est mesuré, et
• une chute de tension parasitaire résultante dans le circuit de test est compensée au moins partiellement au moyen d'un élément de régulation (138).
